# EUROPÄISCHE PATENTANMELDUNG

(11) **EP 1 701 411 A2**
(43) Veröffentlichungstag der Anmeldung: **13.09.2006**
(21) Anmeldenummer: 06004086.2
(22) Anmeldetag: 01.03.2006
(51) Int. Cl.: H01R 9/24

(54) **Anschlussdose für ein Datennetz**

(30) Priorität: 09.03.2005 DE 102005012369
(71) Anmelder: ADC GMBH, 14167 Berlin (DE)
(72) Erfinder: Hetzer, Ulrich, 12679 Berlin (DE); Mössner, Frank, 12277 Berlin (DE); Zimmer, Sabine, 12489 Berlin (DE); Nad, Ferenc, 14197 Berlin (DE)

(57) **Zusammenfassung**

Die Erfindung betrifft eine Anschlussdose (1) für ein Datennetz, umfassend ein Gehäuse (2) und mindestens eine Buchse (53), wobei das Gehäuse (2) aus Kunststoff besteht, wobei die Innenflächen des Gehäuses (2) mindestens teilweise metallisiert sind.

## Beschreibung

Die Erfindung betrifft eine Anschlussdose für ein Datennetz gemäß dem Oberbegriff des Anspruchs 1.

Derartige Anschlussdosen für die Telekommunikations- und Datentechnik umfassen üblicherweise ein Kunststoffgehäuse, in dem meist eine oder zwei Buchsen angeordnet sind. Dabei bildet die Buchse von der Frontseite her eine Aufnahme für einen passenden Stecker, wobei von der Rückseite her ein Kabel anschließbar ist.

Aus der DE 196 04 564 C1 ist eine Anschlussdose für ein Datennetz bekannt, mit einem metallischen Gehäuseunterteil, welches eine zur aufliegenden Montage an einer Wand eingerichtete Aufstandsfläche aufweist, mit einem metallischen Gehäuseoberteil und einer zwischen Gehäuseunterteil und Gehäuseoberteil eingeschlossenen Schaltungsplatine, welche zumindest eine Datensteckbuchse und mehrere Drahtanschlussklemmen trägt, an welche die Einzeladem eines mehradrigen Datenkabels anschließbar sind. Über das metallische Unterteil wird dabei eine Masseverbindung zur Platine hergestellt, über die dann beispielsweise die Schirmung des Kabels mit der Gehäusemasse verbunden werden kann. Über das Gehäuseoberteil und das Gehäuseunterteil wird dann eine überdeckende Kunststoffkappe gezogen.

Der Erfindung liegt das technische Problem zugrunde, eine Anschlussdose für ein Datennetz zu schaffen, das einfacher in Handhabung und Herstellung ist.

Die Lösung des technischen Problems ergibt sich durch den Gegenstand mit den Merkmalen des Anspruchs 1. Weitere vorteilhafte Ausgestaltungen der Erfindung ergeben sich aus den Unteransprüchen.

Hierzu sind die Innenflächen des Kunststoffgehäuses mindestens teilweise metallisiert. Hierdurch kann auf eine separate Kunststoffkappe verzichtet werden, da von außen das Kunststoffgehäuse nicht metallisiert ist. Hierdurch wird aber zumindest ein Teil gegenüber dem Stand der Technik eingespart. Ein weiterer Vorteil des metallisierten Kunststoffgehäuses ist das geringere Gewicht sowie die einfacher zu realisierende Befestigung an Abdeckungen oder dergleichen, wo auf die bekannten Rastverbindungen der Kunststofftechnik zurückgegriffen werden kann.

In einer bevorzugten Ausführungsform sind in dem Gehäuse zwei Buchsen angeordnet, wobei das Gehäuse eine Wand zwischen den beiden Buchsen aufweist, die vollständig metallisiert ist. Diese metallisierte Wand wirkt als Schirmung zwischen den beiden Buchsen und verhindert ein Übersprechen von einer Buchse auf die andere (alien cross talk), unabhängig davon, ob es sich um geschirmte oder ungeschirmte Datenkabel handelt.

In einer weiteren bevorzugten Ausführungsform weist die Wand einen Freischnitt auf, um eine Rastnase der Buchsen aufzunehmen.

In einer weiteren bevorzugten Ausführungsform weisen die Buchsen Kontaktpaare für symmetrische Kabel auf, wobei die Metallisierung des Kunststoffgehäuses derart strukturiert ist, dass die kapazitive Kopplung zwischen den Kontakten eines Kontaktpaares zur Metallisierung gleich groß ist. Dem liegt die Erkenntnis zugrunde, dass es aufgrund einer unsymmetrischen kapazitiven Kopplung der Kontaktpaare zu der Metallisierung zu einem unsymmetrischen Ein- bzw. Auskoppeln in die Masse kommt, was zu einem "alien cross talk" führt, insbesondere bei den hohen Übertragungsfrequenzen von Cat 6 bzw. 10 Gbit/s Ethernet. Durch partielle Flächen ohne Metallisierung wird die symmetrische Kopplung zur Metallisierung erzielt, da die Lage der Kontaktpaare in der Buchse bekannt ist. Somit kann das gleiche Gehäuse gleichzeitig für UTP- (Unshielded Twisted Tair) oder STP- (Shielded Twisted Tair) Kabel Anwendung finden und die geforderten Übersprechwerte für 10Gbit/s Ethernet bzw. STP-Cat 6 einhalten.

In einer weiteren bevorzugten Ausführungsform ist das Kunststoffgehäuse aus zwei Kunststoffen gespritzt, wobei vorzugsweise der äußere Kunststoff ein Polycarbonat und der innere Kunststoff ABS ist, der sich wesentlich leichter galvanisieren lässt als Polycarbonat. Dabei wird die Metallisierung vorzugsweise mittels Galvanisierung auf den Kunststoff aufgebracht, da die damit erreichbaren Widerstandswerte geringer sind als mittels Vakuum-Platinieren oder ähnliche Verfahren.

In einer weiteren bevorzugten Ausführungsform wird von der Rückseite des Gehäuses ein Druckmodul eingesetzt.

Vorzugsweise umfasst das Druckmodul einen Führungskörper, eine Feder und ein Kabelfixierungselement, wobei das Kabelführungselement durch die Feder beaufschlagbar ist. Im einfachsten Fall wirkt das Kabelfixierungselement als Kabelzugentlastung sowie zur mechanischen Verriegelung der eingesetzten Buchse.

In einer weiteren bevorzugten Ausführungsform ist das Kabelführungselement aus Metall oder metallisiertem Kunststoff. Hierdurch ist bei der Verwendung von geschirmten Datenkabeln sehr einfach auch eine elektrische Kabelschirmanbindung möglich, wobei durch die Feder eine gute Kraftnachführung gewährleistet ist. Hierdurch lassen sich sehr einfach Datenkabel unterschiedlichen Durchmessers wieder verbinden.

In einer weiteren bevorzugten Ausführungsform weist das Kabelfixierungselement mindestens eine Rastnase und der Führungskörper mindestens eine Rastmulde auf, so dass die Feder unter Vorspannung in den Führungskörper verrastbar ist. Dadurch kann der Führungskörper sehr einfach zunächst in das Gehäuse eingesetzt und mit diesem verrastet werden. Anschließend kann dann beispielsweise mittels eines Werkzeuges die Rastnase aus der Rastmulde gedrückt werden, so dass das Kabelfixierungselement durch die Feder gegen das Datenkabel drückt und dieses fixiert.

In einer weiteren bevorzugten Ausführungsform weist das Kabelfixierungselement drei Rastnasen auf, wobei zwei Rastnasen seitlich an der der Feder zugewandten Seite und eine Rastnase seitlich an der dem Kabel zugewandten Seite angeordnet sind.

In einer weiteren bevorzugten Ausführungsform ist der Führungskörper seitlich innen mit einer Sägezahnprofilierung ausgebildet. Diese verhindert zusammen mit den beiden hinteren Rastnasen am Kabelfixierungselement ein Zurückgleiten des Kabelfixierungselementes und somit ein Kabelaufbiegen des Datenkabels.

In einer weiteren bevorzugten Ausführungsform ist das Kabelfixierungselement mit einer Kontaktlasche ausgebildet. Über die Kontaktlasche wird eine zweite elektrische Verbindung zur Metallisierung des Gehäuses hergestellt, was die Transferimpedanz reduziert. Hierzu ist die Kontaktlasche vorzugsweise in Richtung der Feder gebogen.

Hinsichtlich einer bevorzugten Ausführungsform der Buchse wird auf die WO 02/15339 verwiesen, auf deren Offenbarungsgehalt hiermit ausdrücklich Bezug genommen wird.

Die Erfindung wird nachfolgend anhand eines bevorzugten Ausführungsbeispieles näher erläutert. Die Fig. zeigen:
Fig. 1 eine Vorderansicht auf die Vorderseite einer Anschlussdose,
Fig. 2 eine Draufsicht auf die Anschlussdose,
Fig. 3 eine perspektivische Rückansicht auf die Anschlussdose mit eingesetzten Druckmodulen,
Fig. 4 eine Schnittdarstellung durch die Anschlussdose entlang der Schnittlinie F-F gemäß Fig. 1,
Fig. 5 eine Draufsicht auf das Druckmodul,
Fig. 6 eine Seitenansicht auf das Druckmodul,
Fig. 7 eine Vorderansicht auf das Druckmodul,
Fig. 8 eine perspektivische Darstellung des Druckmoduls und
Fig. 9 eine perspektivische Rückansicht des Gehäuses ohne Buchsen und Druckmodule.

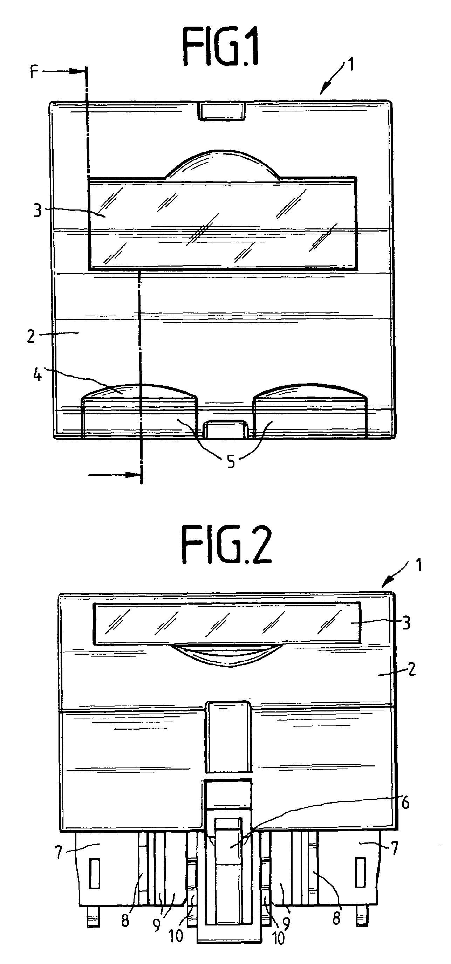

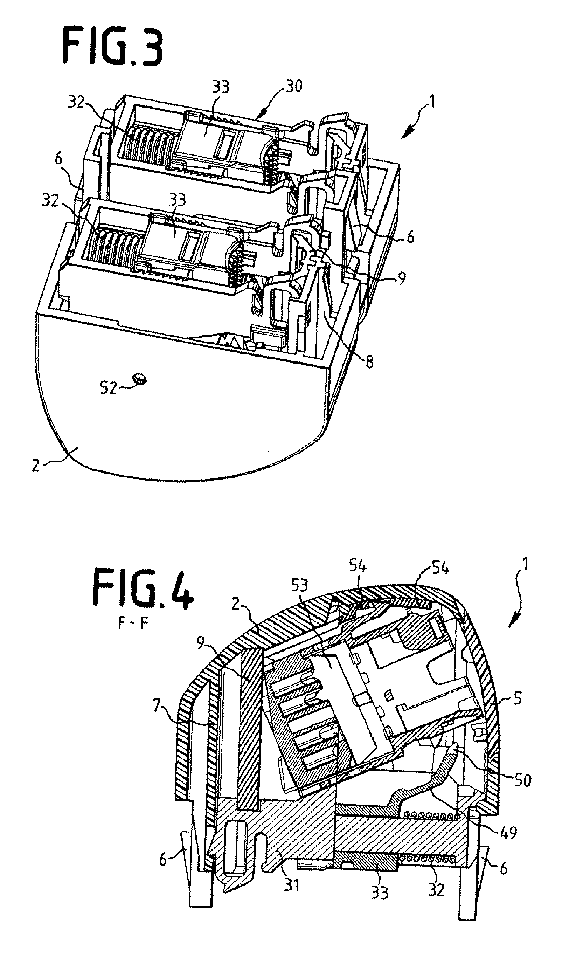

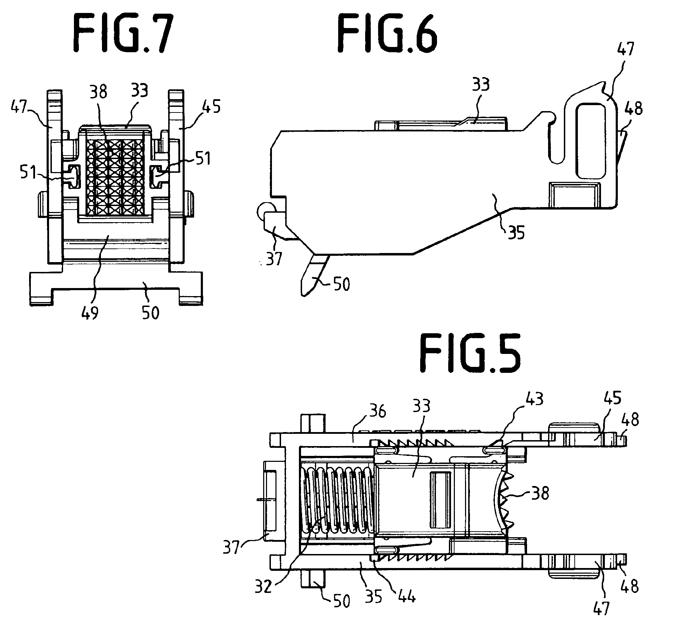

In der Fig. 1 ist eine Vorderansicht auf die Vorderseite des Kunststoffgehäuses 2 der Anschlussdose 1 dargestellt. Relativ zentral ist eine durchsichtige Abdeckung 3 für ein Beschriftungsfeld zu sehen. Im unteren Bereich sind konkave Einbuchtungen 4 zu sehen sowie Klappen 5, mittels derer Aufnahmeöffnungen von Buchsen für Stecker verschließbar sind. Wie man weiter in Fig. 2 erkennen kann, umfasst das Gehäuse 2 einen Rastclip 6, der zum Verrasten des Gehäuses 2 an einem nicht dargestellten Frontrahmen dient. Dabei sei angemerkt, dass auf der gegenüberliegenden Seite ein weiterer, verdeckter Rastclip angeordnet ist, was in Fig. 3 erkennbar ist. Seitlich, am unteren Ende, sind zwei plattenförmige Elemente 7 angeordnet, die jeweils einen schlitzförmigen Durchbruch aufweisen, in dem eine Rastnase 48 eines Rastbügels 45, 47 eines Führungskörpers 31 eines Druckmoduls 30 eingreift (siehe Fig. 6). Auf den plattenförmigen Elementen 7 sind Rippen 8 angeordnet, dessen Verlauf man in Fig. 3 besser erkennt. Nach einem kurzen waagerechten Verlauf fallen diese schräg ab und gehen wieder in einen waagerechten Verlauf über. Neben dem plattenförmigen Element 7 ist die Rückseite eines konkaven Aufnahmeelementes 9 zu sehen, welches das Datenkabel aufnimmt. Die beiden konkaven Aufnahmeelemente 9 sind jeweils metallisiert, wobei die in Fig. 2 sichtbare Rückseite und die Vorderseite sowie die Seitenflächen des Aufnahmeelementes 9 metallisiert und elektrisch verbunden sind. Seitlich vom Rastclip 6 stehen zwei Stege 10 ab, zwischen denen sich im zusammengesetzten Zustand die Rastnase 48 des Rastbügels 45 bzw. 47 befindet.

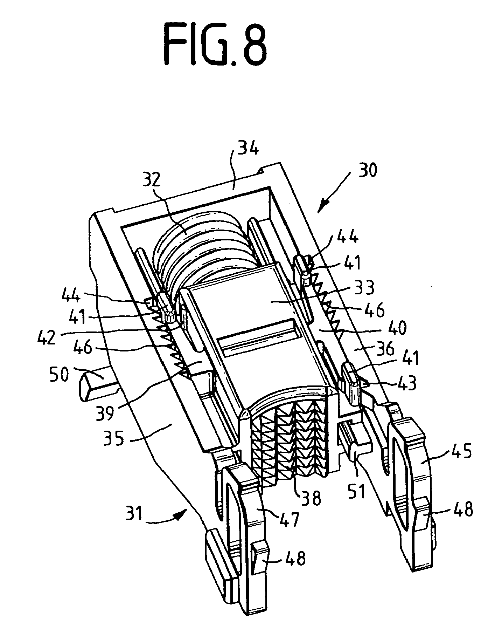

In der Fig. 3 ist die Rückansicht der Anschlussdose 1 mit zwei eingesetzten Druckmodulen 30 dargestellt, die zunächst anhand der Fig. 5 bis 8 näher erläutert werden sollen. Das Druckmodul 30 umfasst einen Führungskörper 31, vorzugsweise aus Kunststoff, eine Feder 32 sowie ein Kabelfixierungselement 33. Die Rückwand 34 und die beiden Seitenwände 35, 36 des Führungskörpers bilden eine im Wesentlichen U-förmige Struktur. An der Rückwand 34 ist eine längliche Struktur angeordnet, auf die die Feder 32 geschoben werden kann. Die längliche Struktur kann dabei im Querschnitt rund oder auch kreuzförmig ausgebildet sein. Außen an der Rückseite der Rückwand 34 ist ein Element 37 zum Einhaken in dem Gehäuse 2 angeordnet. Das Kabelfixierungselement 33 ist an der Stirnseite bogenförmig mit Zähnen 38 ausgebildet, wobei dieser bogenförmige Teil das Gegenstück zum Aufnahmeelement 9 bildet und das Datenkabel gegebenenfalls mit Schirmung zwischen den beiden fixiert wird. Seitlich sind an dem Kabelfixierungselement 33 zwei federnde, bügelförmige Elemente 39, 40 angeordnet. Dabei erstreckt sich das bügelförmige Element 40 mittig fixiert sowohl zur Rückseite als auch zur Stirnseite, wohingegen das bügelförmige Element 39 ausschließlich nach hinten zur Rückseite geführt ist. An den fedemden Enden der bügelförmigen Elemente 39, 40 ist jeweils eine Erhebung 41 angeordnet, die insbesondere zur besseren Betätigung mittels eines Werkzeuges dient. An den Seitenwänden der bügelförmigen Elemente 39, 40 ist im Bereich der Erhebungen 41 jeweils eine Rastnase 42 angeordnet. Im vorgespannten Zustand der Feder rastet die vordere Rastnase 42 in eine Rastmulde 43 und die beiden hinteren Rastnasen 42 in Rastmulden 44. Dieser vorgespannte Zustand ist in den Fig. 5 bis 8 dargestellt, wobei die primäre Halterung durch die vordere Rastnase 42 erfolgt. Wird dann durch Druck auf das bügelförmige Element 40, beispielsweise mittels eines Werkzeuges, seitlich gegen die Erhebung 41 die Rastnase 42 aus der Rastmulde 43 gedrückt, so entspannt sich die Feder 32 und bewegt das Kabelfixierungselement 31 nach vom, bis dieses auf ein Datenkabel stößt bzw. an einem Rastbügel 45 des Führungskörpers 31 einrastet. Hierdurch lassen sich zuverlässig Datenkabel unterschiedlichen Durchmessers sicher fixieren und gegebenenfalls deren Schirmung kontaktieren. An der Innenfläche der Seitenwände 35, 36 ist eine sägezahnartige Profilierung 46 angebracht. Beim Vorschnellen des Kabelfixierungselementes rutschen dann die beiden hinteren Rastnasen 42 über die Profilierung 46, die jedoch ein Zurückschieben verhindert. An dem Rastbügel 45 bzw. 47 ist jeweils eine Rastnase 48 angeordnet. Im zusammengesetzten Zustand (siehe Fig. 3) rastet dabei die eine Rastnase 48 in den schlitzförmigen Durchbruch des plattenförmigen Elementes 7, wohingegen die andere Rastnase 48 zwischen den beiden Stegen 10 liegt. Von der Unterseite des Kabelfixierungselementes 33 geht eine Kontaktlasche 49 ab, an der ein U-förmiges Kontaktelement 50 angeordnet ist. Im zusammengesetzten Zustand kommt das Kontaktelement 50 auf metallisierten Stegen des Gehäuses 2 zum Aufliegen und stellt einen zweiten elektrischen Kontaktpfad zwischen einer Schirmung eines Datenkabels und der Metallisierung des Gehäuses 2 her. Durch diese zwei elektrischen Pfade (über das Aufnahmeelement 9 sowie das Kontaktelement 50) wird die Transfer-Impedanz erheblich verbessert. Des Weiteren ist in den Fig. 7 und 8 jeweils ein T-förmiger Steg 51 zu erkennen, der an den Innenseiten der Seitenwände 35, 36 angeordnet ist und als Führungsschiene für das Kontaktfixierungselement 33 dient.

Wie bereits ausgeführt, ist der zusammengesetzte Zustand der Anschlussdose (ohne Datenkabel) in Fig. 3 dargestellt. Dabei ist an der Seitenwand des Gehäuses 2 eine Öffnung 52 erkennbar. Diese Öffnung 52 nimmt eine Rastnase einer Buchse auf, wohingegen die hierzu korrespondierende Rastnase auf der anderen Seite der Buchse in einem Freischnitt einer Wand zwischen den beiden Buchsen liegt.

In der Fig. 4 ist eine Querschnittsdarstellung entlang des Schnittes F-F gemäß Fig. 1 gezeigt, wobei die Lage der Buchse 53 im Gehäuse 2 erkennbar ist. In Schwarz sind dabei die im Schnitt sichtbaren Metallisierungen 54 des Gehäuses 2 gezeigt.

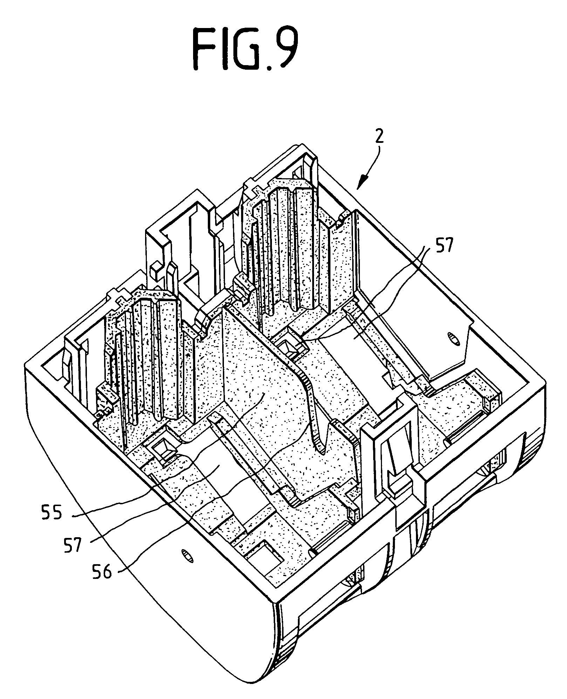

In der Fig. 9 ist schließlich das Gehäuse 2 perspektivisch alleine dargestellt, wobei die Metallisierungen 54 als gepunktete Flächen dargestellt sind. Neben den metallisierten Aufnahmen 9 erkennt man insbesondere die Wand 55 mit dem Freischnitt 56. Des Weiteren sind Flächen 57 zu erkennen, die nicht metallisiert sind. Dabei dienen insbesondere die großen Flächen 57 einem Abgleich der kapazitiven Kopplung der Kontakte eines Kontaktpaares mit der Metallisierung, d.h. beide Kontakte eines Kontaktpaares weisen nahezu die gleiche kapazitive Kopplung auf.

### Bezugszeichenliste

- 1: Anschlussdose
- 2: Kunststoffgehäuse
- 3: Abdeckung
- 4: konkave Einbuchtungen
- 5: Klappen
- 6: Rastclip
- 7: Plattenförmige Elemente
- 8: Rippen
- 9: konkaves Aufnahmeelement
- 10: Stege
- 30: Druckmodul
- 31: Führungskörper
- 32: Feder
- 33: Kabelfixierungselement
- 34: Rückwand
- 35: Seitenwand
- 36: Seitenwand
- 37: bogenförmiges Element
- 38: Zähne
- 39: bügelförmiges Element
- 40: bügelförmiges Element
- 41: Erhebung
- 42: Rastnase
- 43: Rastmulde
- 44: Rastmulde
- 45: Rastbügel
- 46: sägezahnartige Profilierung
- 47: Rastbügel
- 48: Rastnase
- 49: Kontaktlasche
- 50: U-förmiges Kontaktelement
- 51: T-förmige Stege
- 52: Öffnung
- 53: Buchse
- 54: Metallisierungen
- 55: Wand
- 56: Freischnitt
- 57: Flächen

## Patentansprüche

1. Anschlussdose für ein Datennetz, umfassend ein Gehäuseund mindestens eine Buchse, wobei das Gehäuse aus Kunststoff besteht,
**dadurch gekennzeichnet, dass**
die Innenflächen des Gehäuses (2) mindestens teilweise metallisiert sind.

2. Anschlussdose nach Anspruch 1, **dadurch gekennzeichnet, dass** in dem Gehäuse (2) zwei Buchsen (53) angeordnet sind, wobei das Gehäuse (2) eine Wand (55) zwischen den beiden Buchsen (53) aufweist, die vollständig metallisiert ist.

3. Anschlussdose nach Anspruch 2, **dadurch gekennzeichnet, dass** die Wand mindestens einen Freischnitt (56) aufweist.

4. Anschlussdose nach einem der vorangegangenen Ansprüche, **dadurch gekennzeichnet, dass** die Buchsen (53) Kontaktpaare für symmetrische Kabel aufweisen, wobei die Metallisierung (54) derart strukturiert ist, dass die kapazitive Kopplung zwischen den Kontakten eines Kontaktpaares zur Metallisierung (54) gleich groß ist.

5. Anschlussdose nach einem der vorangegangenen Ansprüche, **dadurch gekennzeichnet, dass** das Gehäuse (2) aus zwei Kunststoffen gespritzt ist.

6. Anschlussdose nach Anspruch 5, **dadurch gekennzeichnet, dass** der äußere Kunststoff aus Polycarbonat und der innere Kunststoff aus ABS besteht.

7. Anschlussdose nach einem der vorangegangenen Ansprüche, **dadurch gekennzeichnet, dass** von der Rückseite des Gehäuses (2) ein Druckmodul (30) eingesetzt ist.

8. Anschlussdose nach Anspruch 7, **dadurch gekennzeichnet, dass** das Druckmodul (30) einen Führungskörper (31), eine Feder (32) und ein Kabelfixierungselement (33) umfasst, wobei das Kabelfixierungselement (33) durch die Feder (32) beaufschlagbar ist.

9. Anschlussdose nach Anspruch 8, **dadurch gekennzeichnet, dass** das Kabelfixierungselement (33) aus Metall oder metallisiertem Kunststoff ist.

10. Anschlussdose nach einem der Ansprüche 8 oder 9, **dadurch gekennzeichnet, dass** das Kabelfixierungselement (33) mindestens eine Rastnase (42) und der Führungskörper (31) mindestens eine Rastmulde (43) aufweist, so dass die Feder (32) unter Vorspannung in dem Führungskörper (31) verrastbar ist.

11. Anschlussdose nach Anspruch 10, **dadurch gekennzeichnet, dass** das Kabelfixierungselement (33) drei Rastnasen (42) aufweist, wobei zwei Rastnasen (42) seitlich an der der Feder (32) zugewandten Seite und eine Rastnase (42) seitlich an der dem Kabel zugewandten Seite angeordnet sind.

12. Anschlussdose nach Anspruch 11, **dadurch gekennzeichnet, dass** der Führungskörper (31) seitlich innen mit einer Sägezahnprofilierung (46) ausgebildet ist.

13. Anschlussdose nach einem der Ansprüche 9 bis 12, **dadurch gekennzeichnet, dass** das Kabelfixierungselement (33) mit einer Kontaktlasche (49) ausgebildet ist.

14. Anschlussdose nach Anspruch 13, **dadurch gekennzeichnet, dass** die Kontaktlasche (49) in Richtung der Feder (32) gebogen und mit einem Kontaktelement (50) ausgebildet ist, das die Metallisierung (54) des Kunststoffgehäuses (2) kontaktiert.
